# EUROPEAN PATENT SPECIFICATION

(11) **EP 3 775 348 B1**
(45) Date of publication and mention of the grant of the patent: **26.06.2024**
(21) Application number: 19718937.6
(22) Date of filing: 03.04.2019
(51) Int. Cl.: D04H 11/08, B32B 5/26, B60R 16/02, B65H 81/06, D03D 3/02, F16L 57/00, H02G 3/04, H05K 9/00, B32B 7/09, D04H 1/498, D04H 3/105, B32B 5/06, D04H 1/46, D04H 18/02

(54) **SELF-WRAPPING SLEEVE AND METHOD OF CONSTRUCTION THEREOF**
SELBSTUMHÜLLENDE HÜLSE UND VERFAHREN ZU IHRER HERSTELLUNG
MANCHON AUTO-ENVELOPPANT ET SON PROCÉDÉ DE CONSTRUCTION

(30) Priority: 06.04.2018 US 201862654177 P; 02.10.2018 US 201816150140
(43) Date of publication of application: 17.02.2021
(73) Proprietor: Federal-Mogul Powertrain LLC, Southfield, MI 48034 (US)
(72) Inventor: ITOH, Emi, Kawasaki-shi, Kanagawa-ken 215-0025 (JP); YONESHIGE, Yuki, Tokyo 194-0031 (JP); YAMAGUCHI, Hiroki, Sagamihara, Kanagawa 252-0318 (JP)
(74) Representative: HGF
(86) International application number: PCT/US2019/025507
(87) International publication number: WO 2019/195371

(56) References cited:
- EP-A1- 3 038 823
- WO-A1-96/02382
- WO-A1-03/021736
- US-A1- 2007 166 495
- US-A1- 2011 275 268
- US-A1- 2014 272 224

## Description

### CROSS-REFERENCE TO RELATED APPLICATION

This patent claims the benefit of U.S. Provisional Application Serial No. 62/654,177, filed April 6, 2018, and U.S. Utility Application Serial No. 16/150,140.

### BACKGROUND OF THE DISCLOSURE

### 1. Technical Field

This invention relates generally to protective non-woven sleeves which can be fitted about elongated items such as wires, wire harnesses, pipes, hoses tubing and the like to protect such elongated items from heat, cuts, chafing, abrasion, impact and/or to provide shielding from vibration, noise, electromagnetic interference, and/or harshness.

### 2. Related Art

US Patents 7,523,532 and 7,754,301 disclose a non-woven sleeve for use in covering elongated items, such as wires, wire harnesses, pipes, hoses tubing and the like. Such a non-woven sleeve is taught as being uniformly compressed to a desired density (which can vary depending upon the application) and also biased to a self-curling shape, so that when the sleeve is forced open along its slit edge and positioned about the elongated item, releasing the sleeve causes it to self-curl and wrap about the elongated item. Such a sleeve has the advantage of being self-wrapping and being made of non-woven material, but also has its limitations in that the densified self-curling attribute has the effect of making the product rather stiff and resistant to flexing along its length, which can present a challenge when the sleeve is to be used to cover an elongated item that has serpentine, meandering curvature (e.g., a curved wire harness). Further, although the aforementioned sleeve is useful for providing protection against vibration and noise dampening, it is not generally suited for protection against electromagnetic interference (EMI), radiofrequency interference (RFI), nor electrostatic discharge (ESD). Patent application US 2011/0275268 A1 describes an example of a self-wrapping sleeve for routing and protecting elongate members. The sleeve comprises a wall having at least one non-woven layer and a lattice of heat-settable polymeric material attached to the at least one non-woven layer. A further example of a self-closing sleeve for protecting at least one elongate member is described in patent application US 2014/272224 A1.

### SUMMARY OF THE INVENTION

An embodiment of the invention relates to a self-wrapping sleeve for routing and protecting elongate members as defined in the appended claim 1. The sleeve includes an elongate wall having opposite edges extending along a longitudinal axis of the sleeve between opposite ends of the sleeve. The opposite edges are biased into a self-wrapped configuration about the longitudinal axis to define a tubular cavity. The opposite edges are extendable away from one another under an externally applied force to expose the cavity for insertion or removal of the elongate members and return to their self-wrapped configuration upon removal of the externally applied force. The wall includes a non-woven layer of intertwined fibers (non-woven is a well-known term of art understood to typically be made in a web forming process, such as used by make fiberglass, felt, and the like, by way of example and without limitation) and a textile layer of interlaced filaments (monofilaments and/or multifilaments that are woven, braided or knit with one another), wherein the non-woven layer is fixed to the textile layer via fibers of the non-woven layer being entangled with filaments of the textile layer.

A plurality of circumferentially extending, needled first band portions are formed via the fibers of the non-woven layer being pushed into entanglement with the interlaced filaments of the textile layer, thereby imparting enhanced hoop-strength to the sleeve as a result of the first portions being needled and densified (increased in density by being compacted in the needling process) and doing away with the need for supplemental fixation mechanisms to affix the non-woven layer to the interlaced textile layer, and a plurality circumferentially extending non-needled second band portions extending between, in alternating relation with, the first band portions, wherein the second band portions are free from fibers of the non-woven layer being needled and entangled with filaments of the textile layer, thereby imparting enhanced flexibility to the sleeve by not being densified by a needling process and by not being locked to the textile layer, thereby being free to shift and flex slightly relative thereto.

In accordance with an embodiment, the first band portions and the second band portions provide the wall with a convolute contour, with the needled first band portions forming compacted valleys enhancing the hoop crush strength of the wall and the non-needled second band portions forming peaks and enhancing the ability of the wall be remain round, flexible and non-kinked to enable the sleeve to be routed about meandering paths without opening along a seam of the wall and without kinking.

In accordance with an embodiment, the textile layer can be formed as a woven layer of selected monofilaments and/or multifilaments to provide the desired physical properties to the sleeve, wherein at least some of the filaments can be heat-settable to take on a heat-set shape to facilitate maintaining the sleeve in a self-wrapped, circumferentially closed configuration with the opposite edges overlapping one another.

In accordance with an embodiment, the textile layer can be formed as a braided layer of monofilaments and/or multifilaments to provide the desired physical properties to the sleeve, wherein at least some of the filaments can be heat-settable to take on a heat-set shape to facilitate maintaining the sleeve in a self-wrapped, circumferentially closed configuration with the opposite edges overlapping one another.

In accordance with an embodiment, the textile layer can be formed as a knit layer of monofilaments and/or multifilaments to provide the desired physical properties to the sleeve, wherein at least some of the filaments can be heat-settable to take on a heat-set shape to facilitate maintaining the sleeve in a self-wrapped, circumferentially closed configuration with the opposite edges overlapping one another.

In accordance with another an embodiment, the textile layer can be configured to form an inner surface of the sleeve to provide the desired protection immediately abutting the elongate member contained within the sleeve, which can include avoiding being snagged on the elongate member, which would be more inclined to occur if the non-woven layer were in immediate abutment with the elongate member, and the non-woven layer can be configured to form an outer surface of the sleeve, thereby providing enhanced impact resistance via being able to absorb impact shock forces, while also providing enhanced thermal protection via the relatively densely intertwined relation of the fibers of the non-woven layer, wherein the fibers can be selected to provide the specific nature of protection desired.

In accordance with an embodiment, at least some of the fibers of the non-woven layer can be heat-settable to take on a heat-set shape to facilitate maintaining the sleeve in a self-wrapped, circumferentially closed configuration with the opposite edges overlapping one another.

In accordance with an embodiment, the wall of the sleeve can further include a metal foil layer sandwiched between the non-woven layer and the textile layer, thereby providing protection to the elongate member contained with the sleeve protection against (EMI), (RFI) and (ESD), wherein the fibers of the non-woven layer that are entangled with the textile layer pass through the metal foil layer to lock all the layers to one another without need for supplemental fixation mechanisms.

In accordance with an embodiment, all of the layers of the wall can be fixed to one another solely via the fibers of the non-woven layer being entangled with the filaments of the textile layer, thereby eliminating the need for costly secondary fixation mechanisms, such as adhesives or otherwise.

In accordance with an embodiment, at least one, where if only one layer is heat-settable, cost savings can result by only one layer having to contain more costly heat-settable fibers or filaments, or both, if greater curl force for increased self-wrapping capability is desired, of the non-woven and textile layers of the wall can be heat-set to bias the opposite edges of the wall into overlapping relation with one another.

In accordance with another embodiment of the invention, there is provided a method of constructing a self-wrapping sleeve used to route and protect elongate members as defined in claim 7. The method includes providing an elongate non-woven layer and a textile layer. Further, laying the non-woven layer and the textile layer in overlying relation with one another and needle punching the non-woven layer to entangle fibers of the non-woven layer with filaments of the textile layer to form a multilayered wall having opposite edges of the non-woven and textile layers extending lengthwise between opposite ends. Further yet, heat-setting the wall to bias the wall into a self-wrapped, tubular configuration to define an internal tubular cavity for receipt of an elongate member to be protected therein.

The method further includes forming a plurality of circumferentially extending first band portions via the fibers of the nonwoven layer being entangled with filaments of the textile layer and forming a plurality circumferentially extending second band portions extending between and alternating with the first band portions, wherein the fibers of the nonwoven layer within the second band portions are free from being entangled with filaments of the textile layer, such that the second bands provide enhanced flexibility and anti-kinking properties to the sleeve, while the intertwined first band portions provide enhanced hoop strength to the sleeve.

In accordance with an embodiment, the method can further include forming the wall having a convolute contour via the intertwined first band portions forming valleys via being compressed and densified and the non-intertwined second band portions forming peaks via remaining uncompressed and non-densified, with the densified, intertwined first band portions enhancing the hoop crush strength of the wall and the non-densified, non-intertwined second band portions enhancing the ability of the wall be remain round, highly flexible and non-kinked when bent to enable the sleeve to be routed about meandering, serpentine paths and about corners without opening along a seam of the wall.

In accordance with an embodiment, the method can further include providing the textile layer as a woven layer.

In accordance with an embodiment, the method can further include providing the textile layer as a braided layer.

In accordance with an embodiment, the method can further include providing the textile layer as a knit layer.

In accordance with an embodiment, the method can further include arranging the textile layer to form an inner surface of the sleeve to provide the protection desired and to avoid snagging (getting caught on) with the elongate member being protected and arranging the non-woven layer to form a highly impact resistant, thermally protective outer surface of the sleeve.

In accordance with an embodiment, the method can further include sandwiching a metal foil layer between the non-woven layer and the textile layer to provide EMI, RFI and ESD protective properties to the sleeve, and penetrating the metal foil layer with the fibers of the non-woven layer during the needling process to lock the layers in laminated relation with one another without the need for costly secondary processes and fixation mechanisms.

In accordance with an embodiment, the method can further include fixing the layers of the wall to one another solely via the fibers of the non-woven layer being entangled with the filaments of the textile layer, thereby avoiding costly secondary fixation mechanisms and processes.

In accordance with an embodiment, the method can further include heat-setting at least one or both of the non-woven and textile layers of the wall to bias the opposite edges of the wall into overlapping relation with one another.

### BRIEF DESCRIPTION OF THE DRAWINGS

These and other aspects, features and advantages of the invention will become readily apparent to those skilled in the art in view of the following detailed description of the presently preferred embodiments and best mode, appended claims, and accompanying drawings, in which:
Figure 1 is a perspective view of a sleeve constructed in accordance with an embodiment of the invention;
Figure 2 is a cross-sectional view taken generally along the line 2-2 of Figure 1;
Figure 2A is a view similar to Figure 2 of a sleeve constructed in accordance with another embodiment of the invention;
Figure 3 is a side view of a sleeve constructed in accordance with an aspect of the invention shown be bent into a non-kinked U-shape;
Figure 4 is a schematic illustration of a process used to construct a sleeve in accordance with one embodiment of the invention; and
Figure 4A is a view similar to Figure 4 of a process used to construct a sleeve in accordance with another embodiment of the invention.

### DETAILED DESCRIPTION OF PRESENTLY PREFERRED EMBODIMENTS

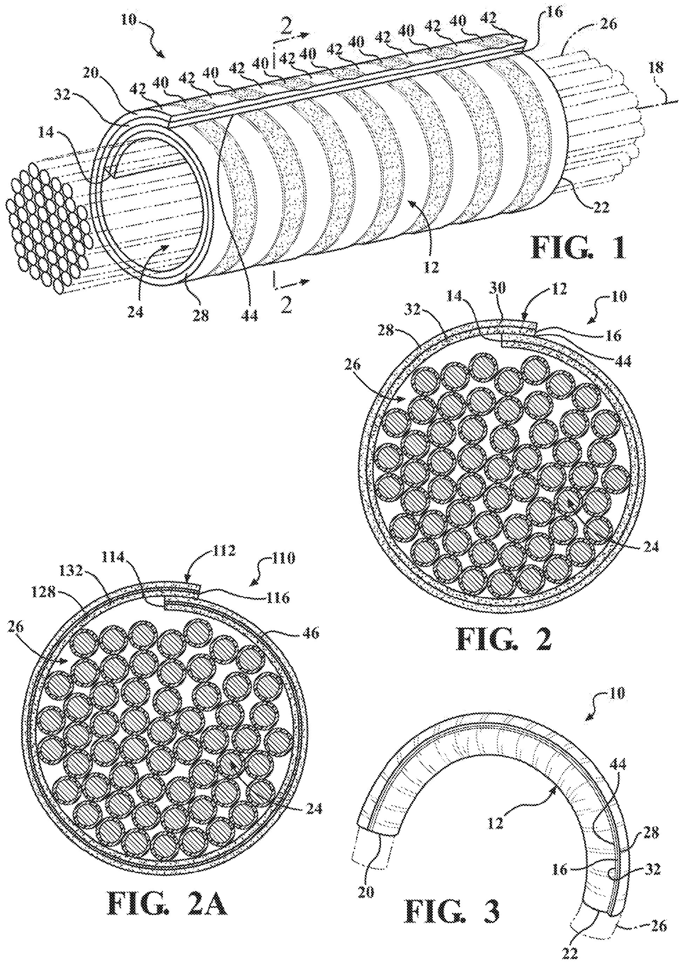

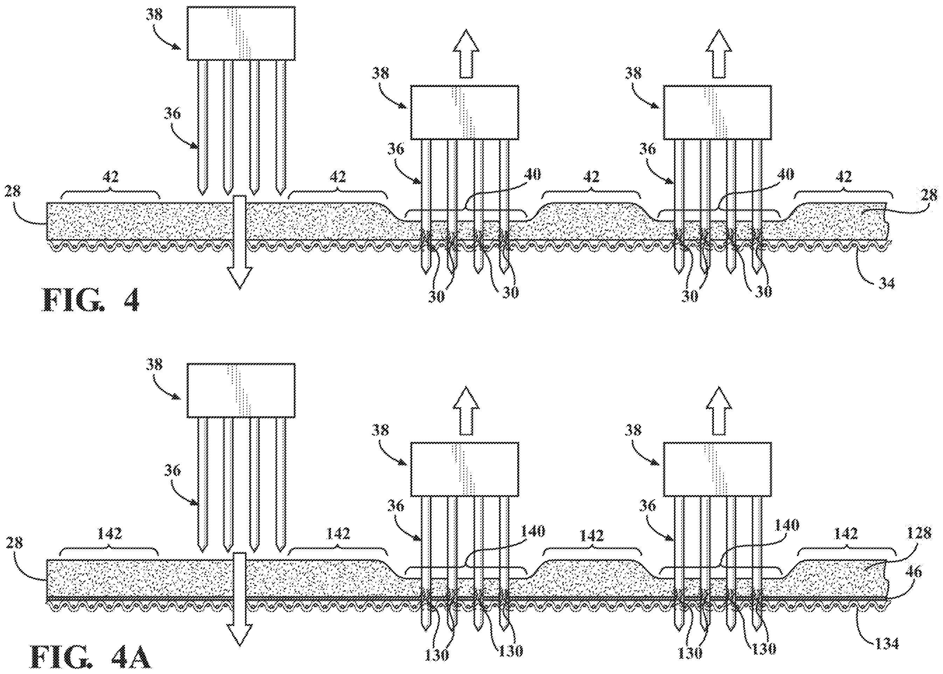

Referring in more detail to the drawings, Figure 1 illustrates a sleeve 10 constructed in accordance with one embodiment of the invention that is self-wrapping as a result of being heat-set in construction. The sleeve 10 has elongate multilayered wall 12 having opposite lengthwise extending edges 14, 16 extending generally parallel with a longitudinal axis 18 of the sleeve 10 between opposite open ends 20, 22 of the sleeve. The opposite edges 14, 16 are biased into self-wrapped, overlapping relation with one another to define a tubular internal cavity 24. The opposite edges 14, 16 are extendable away from one another under an externally applied force, when desired, to expose the internal cavity 24 for insertion or removal of an elongate member(s) 26 and automatically return to their self-wrapped configuration upon removal of the externally applied force. The wall includes an outer non-woven layer 28 of intertwined fibers 30 and an inner textile layer 32 of interlaced filaments 34 (the filaments 34 can be monofilaments and/or multifilaments of any desired material, including heat-settable and/or non-heat-settable materials; and can be interlaced via weaving, braiding, knitting using any desired pattern, e.g. plain weave, if woven, or otherwise), wherein the non-woven layer 28 is fixed to the textile layer 32 via fibers 30 of the non-woven layer 28 being entangled with filaments 34 of the textile layer 32 via a needle punch process, such as illustrated in Figures 4 and 4A. Accordingly, the non-woven layer 28 and the textile layer 32 can be fixed to one another solely via the needling process without the need for costly secondary fixation mechanisms and processes, such as messy, costly adhesives or other types of fastener devices.

In accordance with one embodiment of the invention, as shown in Figure 4, the nonwoven layer 28 and textile layer 32 are initially constructed as flat layers and are fed into overlying relation with one another, with the nonwoven layer 28 facing a plurality of needles 36 of a needle punch machine 38. The needles 36 are arranged in the desired number and pattern to effect the desired needling pattern (width and density) in the nonwoven layer 28. The needle punch machine 38 is cycled to penetrate the nonwoven layer 28 and the underlying textile layer 32 with the needles 36, whereupon the needles 36 carry a plurality of fibers 30 of the nonwoven layer 28 into entangled relation with the filaments 34 of the textile layer 32. Accordingly, the nonwoven layer 28 and the textile layer 32 are fixed to one another against separation without the need for supplemental bonding and fixation mechanisms, such as an adhesive, though it is contemplated herein that such supplemental bonding mechanisms could be used, if desired. The needling is performed to create first and second circumferentially extending bands 40, 42 that alternate with one another along a length of the layers 28, 32. The first bands 40 are formed having compressed, densified needled fibers 30 and the second bands 42 are formed retaining non-compressed, non-densified and non-needled fibers 30. One skilled in the art will understand that the first and second bands 40, 42 can be formed having any desired width (width is intended to mean the distance extending lengthwise along the axis 18) as desired to impart the desired flex, crush strength and impact resistance (crash protection) to the finish sleeve 10. Upon the flat nonwoven and textile layers 28, 32 being needled and laminated (fixed) to one another to form the material of the multilayered wall 12, the wall 12, which takes on a convolute contour with valleys V of needled material forming the first bands 40, which provide enhanced hoop strength, and peaks P of non-needled material forming the second bands 42, which provide enhanced flexibility, can be subsequently wrapped and heat-formed (heat-set) into a biased, self-wrapping tubular configuration to form the tubular sleeve 10. With at least one or both of the layers 28, 32 of the wall 12 being heat-set to take on its curled configuration, a split, also referred to as seam 44, extends along the length of the sleeve 10, wherein the wall 12 provides the circumferentially enclosed internal cavity 24 when in its relaxed, self-wrapped configuration. It is to be understood that only one of the layers 28, 32 may include heat-settable fibers and filaments, respectively, while the other layer 28, 32 may be void, and thus free of more costly heat-settable fibers and filaments, respectively. Contrarily, where increased curl force is desired to enhance the self-wrapping capability of the wall 12, both layers 28, 32 may include heat-settable fibers and filaments, respectively. With the wall 12 being curled, the internal cavity 24 is generally tubular and readily accessible along the entirety of the central longitudinal axis 18 of the sleeve 10 so that the elongate member(s) 26, such as wires or a wire harness, for example, can be readily disposed into the internal cavity 24, and conversely, removed from the internal cavity 24, such as during service via forcing lengthwise extending free edges 14, 16 of the sleeve 10 away from one another against the heat-set bias imparted within at least a portion of the wall 12 to open the seam 44 against the self-closing, heat-formed biasing force by an amount sufficient to introduce or remove the elongated members 26 through the opened split seam 44.

In the embodiment of Figure 2, the non-woven layer 28 and the textile layer 32 form the entirety of the multilayered sleeve 10, unless a further layer is desired, as discussed below. Accordingly, the construction of the sleeve 10 eliminates the requirement for additional layers of material to provide protection or other functions, e.g. curling. The material of the nonwoven layer 28 can be provided, at least in part, of any type and combination of heat-formable fibrous materials. The material may be selected as an abrasion resistant, flexible, resilient, acoustic dampening polymeric material, such as polyester, for example. The exemplary selected fibrous material selected to be incorporated into the nonwoven layer 28 may be, without limitation, polyethylene terephthalate) (PET). The material may include a base polymeric material (such as PET, by way of example and without limitation) combined with any number and type of polymeric or non-polymeric filler materials (e.g., chopped waste fabric, shop rags, Asian cardboard, etc.). The sleeve 10 is well suited to protect the elongate members 26 within the internal cavity 24 against abrasion, vibration, thermal conditions and damage from impact largely via the nonwoven layer 28, while also inhibiting snagging with the elongate members 26, rattling and squeaking, or otherwise producing unwanted harshness and/or noise largely via the textile layer 32. In addition, as a result of the nonwoven layer 28 being needled to the textile layer 32 in the first bands 40 and not needled in the second bands 42, the sleeve 10 can be routed about meandering paths and sharp corners, as illustrated in Figure 3, without causing the seam 44 to open and without causing the wall 12 to kink. The first bands 40 of needled fibers 30 are densified and impart enhanced crush (hoop) strength to the wall, while the second bands 42 of non-needled fibers 30 are not densified via needling, and thus, impart flexibility to the sleeve 10, thereby providing a synergy of enhanced hoop strength and enhanced flexibility that allows the sleeve 10 to function as intended, without jeopardizing the ability of the wall 12 to remain in its fully wrapped state about the elongate member(s) 26. Further yet, the materials and processes used to construct the sleeve 10 are economical in manufacture and in use.

As shown in Figures 2A and 4A, a sleeve 110 constructed in accordance with another embodiment of the invention is provided, wherein the same reference numerals as used above, offset by a factor of 100, are used to identify like features. The sleeve 110 has a wall 112 that includes a nonwoven layer 128, as textile layer 132, and a metal foil layer 46, such as a metal foil layer of aluminum or other suitable metal material, sandwiched between the nonwoven layer 128 and the textile layer 132. The wall 112 is constructed similarly as discussed above for the wall 12; however, prior to performing the needling process, as discussed above, the foil layer 46 is sandwiched between the outer nonwoven layer 128 and the inner textile layer 132. With the respective layers 128, 46, 132 overlying one another, preferably such that their respective outer peripheries are in flush alignment with one another, the needling process is performed, as discussed above, to form the axially alternating first and second bands 140, 142. As best shown in Figure 4A, the needled fibers 130 of the nonwoven layer 128 penetrate through the metal foil layer 46 to entangle with the filaments 134 of the textile layer 132. Accordingly, the respective layers 128, 46, 132 are fixed to one another without need for further fixing mechanisms, as discussed above, though, additional fixing mechanisms could be used, if desired. Of course, cost is reduced if further fixing mechanisms are avoided. Then, upon forming the fixed lamination of the nonwoven layer 128, metal foil layer 46 and textile layer 132, the wall 112 can be heat-formed to permanently bias opposite edges 114, 116 of the wall 112 into overlapping relation with one another to form a tubular sleeve 112. The presence of the metal foil layer 46 enhances protection against thermal effects as well as against electromagnet interference, as will be appreciated by a skilled artisan in view of the disclosure herein.

## Claims

1. A self-wrapping sleeve (10; 110) for routing and protecting elongate members (26), comprising:
an elongate wall (12; 112) having opposite edges (14, 16; 114, 116) extending lengthwise along a longitudinal axis (18) between opposite ends (20, 22), said opposite edges being biased into a self-wrapped configuration about the longitudinal axis to define an internal cavity (24), said opposite edges being extendable away from one another under an externally applied force to expose the internal cavity for insertion or removal of the elongate members and return to their self-wrapped configuration upon removal of the externally applied force;
said wall including a non-woven layer (28; 128) of intertwined fibers (30; 130) and a textile layer (32; 132) of interlaced filaments (34; 134), wherein the non-woven layer is fixed to the textile layer via fibers of the non-woven layer being entangled with filaments of the textile layer; and
**characterised in that** said wall has a plurality of circumferentially extending first band portions (40; 140) and a plurality circumferentially extending second band portions (42; 142) alternating with one another along the length of the sleeve, said first band portions being needle punched with fibers of said nonwoven layer being entangled with said filaments of said textile layer and said second band portions not being needled punched such that said fibers of said non-woven layer are not entangled said filaments of said textile layer.

2. The self-wrapping sleeve (10; 110) of claim 1, wherein at least one of said non-woven layer (28; 128) and said textile layer (32; 132) is heat-set to bias said opposite edges (14, 16; 114, 116) into the self-wrapped configuration about the longitudinal axis (18).

3. The self-wrapping sleeve (10; 110) of claim 2, wherein said non-woven layer (28; 128) is heat-set to bias said opposite edges (14, 16; 114, 116) into the self-wrapped configuration about the longitudinal axis (18), and optionally wherein textile layer (32; 132) is not heat-set.

4. The self-wrapping sleeve (10; 110) of claim 2, wherein said textile layer (32; 132) is heat-set to bias said opposite edges (14, 16; 114, 116) into a self-wrapped configuration about the longitudinal axis (18), and optionally wherein said non-woven layer (28; 128) is not heat-set.

5. The self-wrapping sleeve (10; 110) of claim 2, wherein said non-woven layer (28; 128) and said textile layer (32; 132) are each heat-set to bias said opposite edges (14, 16; 114, 116) into the self-wrapped configuration about the longitudinal axis (18).

6. The self-wrapping sleeve (110) of claim 1, wherein said wall (112) further includes a metal foil layer (46) sandwiched between said non-woven layer (128) and said textile layer (132), wherein said fibers (130) of said non-woven layer entangled with said textile layer (128) pass through said metal foil layer, and optionally wherein said nonwoven layer, said textile layer and said metal foil layer are fixed to one another solely via said fibers of said non-woven layer being entangled with said filaments of said textile layer.

7. A method of construction a self-wrapping sleeve (10; 110), comprising:
providing an elongate non-woven layer (28; 128) of intertwined fibers (30; 130);
providing a textile layer (32; 132) of interlaced filaments (34; 134);
laying the non-woven layer and the textile layer in overlying relation with one another;
needle punching the non-woven layer to entangle fibers (30; 130) of the non-woven layer with filaments (34; 134) of the textile layer to form a multilayered wall (12; 112) having opposite edges (14, 16; 114, 116) of the non-woven layer and the textile layer extending lengthwise between opposite ends (20, 22); and
heat-setting the wall into a tubular self-wrapped configuration with the opposite edges being biased into overlapping relation with one another to define an internal cavity (24);
**characterised in that** the method further includes needling a plurality of circumferentially extending first band portions (40; 140) in the nonwoven layer causing the fibers of the nonwoven layer to become entangled with filaments of the textile layer and forming a plurality circumferentially extending non-needled second band portions (42; 142) extending between and alternating with the first band portions, wherein the fibers of the nonwoven layer within the second band portions are free from being entangled with filaments of the textile layer.

8. The method of claim 7, further including forming the wall (12; 112) having a convolute contour via the first band portions (40; 140) forming valleys and the second band portions (42; 142) forming peaks.

9. The method of claim 7, further including arranging the textile layer (32; 132) to form an inner surface of the sleeve (10; 110) and arranging the non-woven layer (28; 128) to form an outer surface of the sleeve.

10. The method of claim 7, further including sandwiching a metal foil layer (46) between the non-woven layer (128) and the textile layer (132) and penetrating the metal foil layer with the fibers (130) of the non-woven layer that are entangled with the textile layer.

11. The method of claim 7, further including fixing the nonwoven layer (28; 128) and the textile layer (32; 132) to one another solely via the fibers (30; 130) of the non-woven layer being entangled with the filaments (34; 134) of the textile layer.

12. The method of claim 7, further including imparting a heat-set in at least one of the non-woven layer (28; 128) and the textile layer (32; 132) to bias the opposite edges (14, 15; 114, 116) of the wall (12; 112) into overlapping relation with one another without imparting a heat-set in the other of the non-woven layer and the textile layer.

13. The method of claim 12, further including imparting a heat-set in the non-woven layer (28; 128).

14. The method of claim 12, further including imparting a heat-set in the textile layer (32; 132).

15. The method of claim 7, further including imparting a heat-set in both the non-woven layer (28; 128) and the textile layer (30; 130) to bias the opposite edges (14, 16; 114, 116) of the wall (12; 112) into overlapping relation with one another without heat-setting the other of the non-woven layer and the textile layer.

## Patentansprüche

1. Selbstumhüllende Hülse (10; 110) zum Führen und Schützen von länglichen Elementen (26), umfassend:
eine längliche Wand (12; 112) mit gegenüberliegenden Kanten (14, 16; 114, 116), die sich längs entlang einer Längsachse (18) zwischen gegenüberliegenden Enden (20, 22) erstrecken, wobei die gegenüberliegenden Kanten in eine selbstumhüllte Konfiguration um die Längsachse vorgespannt sind, um einen inneren Hohlraum (24) zu definieren, wobei die gegenüberliegenden Kanten unter einer von außen ausgeübten Kraft voneinander weg erweiterbar sind, um den inneren Hohlraum zur Einführung oder Entfernung der länglichen Elemente freizugeben und in ihre selbstumhüllte Konfiguration nach Entfernung der von außen ausgeübten Kraft zurückzukehren;
wobei die Wand eine Vliesschicht (28; 128) aus verwobenen Fasern (30; 130) und eine Textilschicht (32; 132) aus verflochtenen Filamenten (34; 134) beinhaltet, wobei die Vliesschicht an der Textilschicht über Fasern der Vliesschicht, die mit Filamenten der Textilschicht verwickelt sind, befestigt ist; und
**dadurch gekennzeichnet, dass** die Wand eine Vielzahl von sich umlaufend erstreckenden ersten Bandabschnitten (40; 140) und eine Vielzahl von sich umlaufend erstreckenden zweiten Bandabschnitten (42; 142) aufweist, die sich entlang der Länge der Hülse untereinander abwechseln, wobei die ersten Bandabschnitte mit Fasern der Vliesschicht vernadelt sind, die mit den Filamenten der Textilschicht verwickelt sind, und die zweiten Bandabschnitte nicht vernadelt sind, sodass die Fasern der Vliesschicht nicht mit den Filamenten der Textilschicht verwickelt sind.

2. Selbstumhüllende Hülse (10; 110) nach Anspruch 1, wobei zumindest eine von der Vliesschicht (28; 128) und der Textilschicht (32; 132) wärmefixiert ist, um die gegenüberliegenden Kanten (14, 16; 114, 116) in die selbstumhüllte Konfiguration um die Längsachse (18) vorzuspannen.

3. Selbstumhüllende Hülse (10; 110) nach Anspruch 2, wobei die Vliesschicht (28; 128) wärmefixiert ist, um die gegenüberliegenden Kanten (14, 16; 114, 116) in die selbstumhüllte Konfiguration um die Längsachse (18) vorzuspannen, und wobei optional die Textilschicht (32; 132) nicht wärmefixiert ist.

4. Selbstumhüllende Hülse (10; 110) nach Anspruch 2, wobei die Textilschicht (32; 132) wärmefixiert ist, um die gegenüberliegenden Kanten (14, 16; 114, 116) in eine selbstumhüllte Konfiguration um die Längsachse (18) vorzuspannen, und wobei optional die Vliesschicht (28; 128) nicht wärmefixiert ist.

5. Selbstumhüllende Hülse (10; 110) nach Anspruch 2, wobei die Vliesschicht (28; 128) und die Textilschicht (32; 132) jeweils wärmefixiert sind, um die gegenüberliegenden Kanten (14, 16; 114, 116) in die selbstumhüllte Konfiguration um die Längsachse (18) vorzuspannen.

6. Selbstumhüllende Hülse (110) nach Anspruch 1, wobei die Wand (112) ferner eine Metallfolienschicht (46) beinhaltet, die zwischen der Vliesschicht (128) und der Textilschicht (132) eingefügt ist, wobei die Fasern (130) der Vliesschicht, die mit der Textilschicht (128) verwickelt sind, durch die Metallfolienschicht verlaufen, und wobei optional die Vliesschicht, die Textilschicht und die Metallfolienschicht ausschließlich über die Fasern der Vliesschicht, die mit den Filamenten der Textilschicht verwickelt sind, aneinander befestigt sind.

7. Verfahren zur Herstellung einer selbstumhüllenden Hülse (10; 110), umfassend:
Bereitstellen einer länglichen Vliesschicht (28; 128) aus verwobenen Fasern (30; 130);
Bereitstellen einer Textilschicht (32; 132) aus verflochtenen Filamenten (34; 134);
Legen der Vliesschicht und der Textilschicht in übereinanderliegender Beziehung zueinander;
Vernadeln der Vliesschicht, um Fasern (30; 130) der Vliesschicht mit Filamenten (34; 134) der Textilschicht zu verwickeln, um eine mehrschichtige Wand (12; 112) mit gegenüberliegenden Kanten (14, 16; 114, 116) der Vliesschicht und der Textilschicht zu bilden, die sich längs zwischen gegenüberliegenden Enden (20, 22) erstrecken; und
Wärmefixieren der Wand in eine röhrenförmige selbstumhüllte Konfiguration, wobei die gegenüberliegenden Kanten in überlappende Beziehung zueinander vorgespannt sind, um einen inneren Hohlraum (24) zu definieren;
**dadurch gekennzeichnet, dass** das Verfahren ferner Vernadeln einer Vielzahl von sich umlaufend erstreckenden ersten Bandabschnitten (40; 140) in der Vliesschicht beinhaltet, wodurch bewirkt wird, dass die Fasern der Vliesschicht mit Filamenten der Textilschicht verwickelt werden und eine Vielzahl von sich umlaufend erstreckenden nicht vernadelten zweiten Bandabschnitten (42; 142) bilden, die sich zwischen den ersten Bandabschnitten erstrecken und damit abwechseln, wobei die Fasern der Vliesschicht innerhalb der zweiten Bandabschnitte frei davon sind, mit Filamenten der Textilschicht verwickelt zu sein.

8. Verfahren nach Anspruch 7, ferner beinhaltend Bilden der Wand (12; 112) mit einer gewundenen Kontur über die ersten Bandabschnitte (40; 140), die Täler bilden, und die zweiten Bandabschnitte (42; 142), die Spitzen bilden.

9. Verfahren nach Anspruch 7, ferner beinhaltend Anordnen der Textilschicht (32; 132), um eine Innenfläche der Hülse (10; 110) zu bilden, und Anordnen der Vliesschicht (28; 128), um eine Außenfläche der Hülse zu bilden.

10. Verfahren nach Anspruch 7, ferner beinhaltend Einfügen einer Metallfolienschicht (46) zwischen der Vliesschicht (128) und der Textilschicht (132) und Durchdringen der Metallfolienschicht mit den Fasern (130) der Vliesschicht, die mit der Textilschicht verwickelt sind.

11. Verfahren nach Anspruch 7, ferner beinhaltend Befestigen der Vliesschicht (28; 128) und der Textilschicht (32; 132) aneinander ausschließlich über die Fasern (30; 130) der Vliesschicht, die mit den Filamenten (34; 134) der Textilschicht verwickelt sind.

12. Verfahren nach Anspruch 7, ferner beinhaltend Verleihen einer Wärmefixierung in zumindest einer von der Vliesschicht (28; 128) und der Textilschicht (32; 132), um die gegenüberliegenden Kanten (14, 15; 114, 116) der Wand (12; 112) in überlappende Beziehung zueinander vorzuspannen, ohne eine Wärmefixierung in der anderen von der Vliesschicht und der Textilschicht zu verleihen.

13. Verfahren nach Anspruch 12, ferner beinhaltend Verleihen einer Wärmefixierung in der Vliesschicht (28; 128).

14. Verfahren nach Anspruch 12, ferner beinhaltend Verleihen einer Wärmefixierung in der Textilschicht (32; 132).

15. Verfahren nach Anspruch 7, ferner beinhaltend Verleihen einer Wärmefixierung sowohl in der Vliesschicht (28; 128) als auch in der Textilschicht (30; 130), um die gegenüberliegenden Kanten (14, 16; 114, 116) der Wand (12; 112) in überlappende Beziehung zueinander vorzuspannen, ohne die andere von der Vliesschicht und der Textilschicht wärmezufixieren.

## Revendications

1. Manchon auto-enveloppant (10 ; 110) permettant l'acheminement et la protection d'éléments allongés (26), comprenant :
une paroi allongée (12 ; 112) ayant des bords opposés (14, 16 ; 114, 116) s'étendant dans le sens de la longueur le long d'un axe longitudinal (18) entre des extrémités opposées (20, 22), lesdits bords opposés étant sollicités dans une configuration auto-enveloppée autour de l'axe longitudinal pour définir une cavité interne (24), lesdits bords opposés étant extensibles en éloignement l'un de l'autre sous une force appliquée de l'extérieur pour exposer la cavité interne pour l'insertion ou le retrait des éléments allongés et revenir à leur configuration auto-enveloppée lors du retrait de la force appliquée de l'extérieur ;
ladite paroi comprenant une couche non tissée (28 ; 128) de fibres entortillées (30 ; 130) et une couche textile (32 ; 132) de filaments entrelacés (34 ; 134), dans lequel la couche non tissée est fixée à la couche textile via les fibres de la couche non tissée étant enchevêtrées avec les filaments de la couche textile ; et
**caractérisé en ce que** ladite paroi présente une pluralité de premières parties de bande (40 ; 140) s'étendant circonférentiellement et une pluralité de secondes parties de bande (42 ; 142) s'étendant circonférentiellement en alternance les unes avec les autres sur la longueur du manchon, lesdites premières parties de bande étant aiguilletées avec les fibres de ladite couche non tissée étant enchevêtrées avec lesdits filaments de ladite couche textile et lesdites secondes parties de bande n'étant pas aiguilletées de telle sorte que lesdites fibres de ladite couche non tissée ne soient pas enchevêtrées avec lesdits filaments de ladite couche textile.

2. Manchon auto-enveloppant (10 ; 110) selon la revendication 1, dans lequel au moins l'une de ladite couche non tissée (28 ; 128) et de ladite couche textile (32 ; 132) est thermofixée pour solliciter lesdits bords opposés (14, 16; 114, 116) dans la configuration auto-enveloppée autour de l'axe longitudinal (18).

3. Manchon auto-enveloppant (10 ; 110) selon la revendication 2, dans lequel ladite couche non tissée (28 ; 128) est thermofixée pour solliciter lesdits bords opposés (14, 16 ; 114, 116) dans la configuration auto-enveloppée autour de l'axe longitudinal (18), et éventuellement dans lequel la couche textile (32 ; 132) n'est pas thermofixée.

4. Manchon auto-enveloppant (10 ; 110) selon la revendication 2, dans lequel ladite couche textile (32 ; 132) est thermofixée pour solliciter lesdits bords opposés (14, 16 ; 114, 116) dans une configuration auto-enveloppée autour de l'axe longitudinal (18), et éventuellement dans lequel ladite couche non tissée (28 ; 128) n'est pas thermofixée.

5. Manchon auto-enveloppant (10 ; 110) selon la revendication 2, dans lequel ladite couche non tissée (28 ; 128) et ladite couche textile (32 ; 132) sont chacune thermofixées pour solliciter lesdits bords opposés (14, 16 ; 114, 116) dans la configuration auto-enveloppée autour de l'axe longitudinal (18).

6. Manchon auto-enveloppant (110) selon la revendication 1, dans lequel ladite paroi (112) comprend en outre une couche de feuille métallique (46) prise en sandwich entre ladite couche non tissée (128) et ladite couche textile (132), dans lequel lesdites fibres (130) de ladite couche non tissée enchevêtrée avec ladite couche textile (128) passent à travers ladite couche de feuille métallique, et facultativement dans lequel ladite couche non tissée, ladite couche textile et ladite couche de feuille métallique sont fixées les unes aux autres uniquement via lesdites fibres de ladite couche non tissée étant enchevêtrées avec lesdits filaments de ladite couche textile.

7. Procédé de construction d'un manchon auto-enveloppant (10 ; 110), comprenant :
la fourniture d'une couche non tissée allongée (28 ; 128) de fibres entortillées (30 ; 130) ;
la fourniture d'une couche textile (32 ; 132) de filaments entrelacés (34 ; 134) ;
la pose de la couche non tissée et la couche textile en relation superposée l'une avec l'autre ;
l'aiguilletage de la couche non tissée pour enchevêtrer les fibres (30 ; 130) de la couche non tissée avec les filaments (34 ; 134) de la couche textile pour former une paroi multicouche (12 ; 112) ayant les bords opposés (14, 16 ; 114, 116) de la couche non tissée et de la couche textile s'étendant longitudinalement entre les extrémités opposées (20, 22) ; et
le thermofixage de la paroi dans une configuration tubulaire auto-enveloppée, les bords opposés étant sollicités en relation de chevauchement l'un avec l'autre pour définir une cavité interne (24) ;
**caractérisé en ce que** le procédé comprend en outre le liage par aiguille d'une pluralité de premières parties de bande (40 ; 140) s'étendant circonférentiellement dans la couche non tissée, amenant les fibres de la couche non tissée à s'enchevêtrer avec les filaments de la couche textile et la formation d'une pluralité de secondes parties de bande (42 ; 142) non aiguilletées s'étendant circonférentiellement, s'étendant entre les premières parties de bande et alternant avec celles-ci, dans lequel les fibres de la couche non tissée à l'intérieur des secondes parties de bande sont libres de s'enchevêtrer avec les filaments de la couche textile.

8. Procédé selon la revendication 7, comprenant en outre la formation de la paroi (12 ; 112) ayant un contour convoluté via les premières parties de bande (40 ; 140) formant des vallées et les secondes parties de bande (42 ; 142) formant des sommets.

9. Procédé selon la revendication 7, comprenant en outre l'agencement de la couche textile (32 ; 132) pour former une surface interne du manchon (10 ; 110) et l'agencement de la couche non tissée (28 ; 128) pour former une surface externe du manchon.

10. Procédé selon la revendication 7, comprenant en outre la prise en sandwich d'une couche de feuille métallique (46) entre la couche non tissée (128) et la couche textile (132) et la pénétration de la couche de feuille métallique avec les fibres (130) de la couche non tissée qui sont enchevêtrées avec la couche textile.

11. Procédé selon la revendication 7, comprenant en outre la fixation de la couche non tissée (28 ; 128) et de la couche textile (32 ; 132) l'une à l'autre uniquement via les fibres (30 ; 130) de la couche non tissée étant enchevêtrées avec les filaments (34 ; 134) de la couche textile.

12. Procédé selon la revendication 7, comprenant en outre le fait de conférer un thermofixage à au moins l'une de la couche non tissée (28 ; 128) et la couche textile (32 ; 132) pour solliciter les bords opposés (14, 15 ; 114, 116) de la paroi (12 ; 112) en relation de chevauchement l'un avec l'autre sans conférer un thermofixage à l'autre de la couche non tissée et la couche textile.

13. Procédé selon la revendication 12, comprenant en outre le fait de conférer un thermofixage à la couche non tissée (28 ; 128).

14. Procédé selon la revendication 12, comprenant en outre le fait de conférer un thermofixage à la couche textile (32 ; 132).

15. Procédé selon la revendication 7, comprenant en outre le fait de conférer un thermofixage à la fois à la couche non tissée (28 ; 128) et à la couche textile (30 ; 130) pour solliciter les bords opposés (14, 16 ; 114, 116) de la paroi (12 ; 112) en relation de chevauchement l'un avec l'autre sans thermofixer l'autre de la couche non tissée et de la couche textile.
